# FASCICULE DE BREVET EUROPEEN

(11) **EP 2 162 990 B1**
(45) Date de publication et mention de la délivrance du brevet: **06.07.2011**
(21) Numéro de dépôt: 08760009.4
(22) Date de dépôt: 26.05.2008
(51) Int. Cl.: H03M 13/27, H04L 1/00

(54) **ENTRELACEUR ET DISPOSITIF DE SELECTION DE SERVICES, POUR UN RESEAU DE COMMUNICATION RADIO A LONG ENTRELACEMENT TEMPOREL AU NIVEAU DE LA COUCHE PHYSIQUE**
VERSCHACHTELER UND EINRICHTUNG ZUM AUSWÄHLEN VON DIENSTEN FÜR EIN FUNKKOMMUNIKATIONSNETZ MIT LANGZEITVERSCHACHTELUNG AUF DER EBENE DER PHYSIKALISCHEN SCHICHT
INTERLEAVER AND DEVICE FOR SELECTING SERVICES, FOR A RADIOCOMMUNICATION NETWORK WITH LONG TIME INTERLEAVING AT THE LEVEL OF THE PHYSICAL LAYER

(30) Priorité: 26.06.2007 FR 0756031
(43) Date de publication de la demande: 17.03.2010
(73) Titulaire: Alcatel Lucent, 75008 Paris (FR)
(72) Inventeur: CORBEL, Erwan, F-31270 Villeneuve-Tolosane (FR); COURSEILLE, Olivier, F-31320 Auzeville (FR); RIGAL, Christian, F-31120 Portet Sur Garonne (FR); ROULLET, Laurent, F-91440 Bures (FR)
(74) Mandataire: Ameline, Jean-Paul B.C.
(86) Numéro de dépôt international: PCT/EP2008/056410
(87) Numéro de publication internationale: WO 2009/000603

(56) Documents cités:
- WO-A-03/079601
- US-A1- 2005 251 726
- US-A1- 2007 002 871

## Description

L'invention concerne la transmission de contenus, de type multimédia, via un réseau de communication radio mettant en oeuvre un entrelacement (ou « interleaving ») temporel de longue durée au niveau de la couche physique, et plus précisément l'entrelacement et le désentrelacement temporels, au sein de tels réseaux, d'unités parfois dites d'entrelacement (ou IU, notamment dans les réseaux de type DVB-SH et SDR) définies à partir des paquets de données de contenus multimédia à transmettre.

On entend ici par « contenus multimédia » des ensembles de données d'un même type, comme par exemple des programmes de télévision ou de radio, des fichiers de données (ou « data » en anglais) ou des vidéos.

Par ailleurs, on entend ici par « réseau de communication radio » tout type de réseau radio satellitaire et/ou terrestre mettant en oeuvre un entrelacement temporel de longue durée au niveau de la couche physique en vue de la diffusion de contenus multimédia. Il pourra par exemple s'agir d'un réseau SDR (« Satellite Digital Radio») ou d'un réseau hybride de type DVB-SH (réseau radio de type DVB-H (« Digital Video Broadcasting Handhelds ») mais adapté aux liaisons satellitaires, dans la bande S (environ 2,20 GHz) - télévision mobile par satellites et par relais terrestres). D'une manière générale l'invention concerne tout réseau susceptible de faire l'objet d'évanouissements importants des signaux.

Comme le sait l'homme de l'art, lorsque certains signaux radio (ou hertziens) se propagent, ils peuvent faire l'objet d'interférences multi-trajets, d'atténuations et d'interceptions passagères. C'est fréquemment le cas lorsque les signaux se propagent dans un canal satellitaire. Afin de limiter l'impact des interférences, atténuations et interceptions, il est possible de mettre en oeuvre côté transmission une technique d'entrelacement (ou «interleaving ») temporel au niveau de la couche physique, c'est-a-dire au niveau des paquets de données de contenus à transmettre. C'est notamment ce qui est fait dans les réseaux de type DVB-SH.

Dans les réseaux concernés par l'invention, la longueur (ou constante de temps) de l'entrelacement temporel au niveau de la couche physique est (très) grande devant la constante de temps qui est utilisée dans la couche de service. Elle peut atteindre jusqu'à 10 secondes.

Il est rappelé que les trames TDMA (« Time Division Multiple Access» - multiplexage temporel) qui sont délivrées par la couche de services sont constituées par un nombre prédéfini (par exemple 9) de rafales (ou « bursts ») de paquets de type MPEG, qui sont respectivement associées à des services. Ces paquets sont encodés au moyen d'une technique de correction d'erreurs de type FEC (« Forward Error Correction ») ainsi qu'en plus (éventuellement) MPE-FEC (« Multi-Protocol Encapsulation - FEC »), afin de constituer des mots codés. Chaque rafale de mots codés est alors décomposée en unités d'entrelacement (IUs). Les unités d'entrelacement des différentes rafales d'une trame sont ensuite réparties (ou étalées) par l'entrelaceur sur tout l'intervalle temporel qui est occupé par une période d'un entrelacement temporel. L'unité d'entrelacement est le plus petit ensemble de bits (issus de paquets de contenu) qui est traité par un entrelaceur.

On comprendra donc que si l'on veut reconstituer dans un terminal récepteur toutes les rafales d'une trame entrelacée, il faut actuellement stocker dans une mémoire externe toutes les unités d'entrelacement qui sont contenues dans une période de l'entrelacement temporel, ce qui peut requérir une grande quantité de mémoire. A titre d'exemple non limitatif, dans le cas d'un réseau de type DVB-SH utilisant une modulation 16QAM (respectivement QPSK) et une longueur d'entrelacement temporel égale à 8 secondes, on doit prévoir dans le terminal récepteur une mémoire externe d'environ 256 Mb (Mégabits) (respectivement 128 Mb) pour stocker les données contenues dans un entrelacement temporel. Ce besoin d'utiliser une mémoire de grande capacité constitue une importante contrainte lorsque l'on désire fabriquer des terminaux récepteurs dé coût et de complexité réduits,

Il serait certes possible d'effectuer l'entrelacement temporel dans une couche située à un niveau supérieur a celui de la couche physique. Ces couches de niveaux supérieurs bénéficient en effet de la non quantification des bits de données et de débits de codes plus petits qui permettent d'effectuer un entrelacement temporel de longueur similaire à celle obtenue au niveau de la couche physique; mais qui requièrent beaucoup moins de capacité de mémorisation (typiquement 10 fois moins). Cependant, la technique de correction d'erreur FEC ainsi qu'en plus (éventuellement) MPE-FEC, qui est appliquée avant la technique d'entrelacement temporel, est sensiblement plus efficace lorsqu'elle est appliquée au niveau de la couche physique, à efficacité spectrale identique. En outre, l'entrelacement au niveau de la couche MPE-FEC, qui est placée au-dessus de la couche physique, est sensiblement moins efficace que celui de cette couche physique, et la signalisation de cette couche MPE-FEC n'est plus valable en raison de la durée d'entrelacement de la couche physique.

L'invention a donc pour but d'améliorer la situation.

Le document US 2007/002871 A1 (PEKONEN HARRI J et al), 4 janvier 2007 (04.01.2007), paragraphs [0002, 0007], fig.7 propose un entrelaceur d'unités d'entrelacement (représentant un nombre choisi de services regroupés dans des trames périodiques), pour un réseau de communication radio à entrelacement temporel de longue période.

L'entrelaceur selon la présente invention se caractérise par le fait qu'il comprend des moyens de traitement chargés de décomposer chaque trame en un nombre choisi de groupes de service(s) de durées respectives constantes, puis de répartir les unités d'entrelacement de chaque groupe dans des intervalles temporels dits d'étalement de durées respectives constantes et espacés au sein d'une période de l'entrelacement temporel selon une période égale à la période des trames.

De préférence, les moyens de traitement sont chargés de répartir les unités d'entrelacement de chaque groupe dans des intervalles temporels d'étalement dont les durées respectives sont constantes et petites par rapport à la période des trames.

L'invention propose également un dispositif de sélection de services, représentés par des unités d'entrelacement entrelacées au moyen d'un entrelaceur du type de celui présenté ci-avant, pour une réseau de communication radio à entrelacement temporel de longue période.

Ce dispositif se caractérise par le fait qu'il comprend des moyens de traitement synchronisés par rapport à l'entrelaceur et chargés, en cas de sélection d'un groupe de services à traiter, de se mettre en fonctionnement périodiquement pendant au moins la durée de chaque intervalle temporel d'étalement du groupe sélectionné, et donc selon une période égale à la période des trames, afin de collecter toutes les unités d'entrelacement entrelacées qui sont contenues dans les intervalles temporels d'étalement du groupe sélectionné compris dans une période de l'entrelacement temporel.

Le dispositif selon l'invention peut comporter d'autres caractéristiques qui peuvent être prises séparément ou en combinaison, et notamment :
- il peut comprendre des moyens de mémorisation pour stocker des unités d'entrelacement entrelacées. Dans ce cas, ses moyens de traitement peuvent être chargés de stocker dans les moyens de mémorisation, lors de chaque période de l'entrelacement temporel, toutes les unités d'entrelacement entrelacées qui sont contenues dans les intervalles temporels d'étalement du groupe sélectionné qui sont compris dans la période en cours de l'entrelacement temporel;
- en variante, il peut comprendre des moyens de filtrage chargés de retenir parmi les unités d'entrelacement entrelacées qui ont été collectées celles qui représentent les services du groupe sélectionné ;
   ➢ il peut comprendre des moyens de mémorisation pour stocker des unités d'entrelacement Dans .ce cas, ses moyens de filtrage peuvent être chargés de stocker dans les moyens de mémorisation, lors de chaque période de l'entrelacement temporel les unités d'entrelacement entrelacées qui ont été retenues dans les intervalles temporels d'étalement du groupe sélectionné qui sont compris dans la période en cours de l'entrelacement temporel.

L'invention propose également un procédé d'entrelacement d'unités d'entrelacement, pour un réseau de communication radio à entrelacement temporel de longue période.

Ce procédé d'entrelacement se caractérise par le fait qu'il consiste à décomposer chaque trame en un nombre choisi de groupes de service(s) de durées respectives constantes, puis a répartir les unités d'entrelacement de chaque groupe dans des intervalles temporels dits d'étalement de durées respectives constantes et espacés au sein d'une période de l'entrelacement temporel selon une période égale à la période des trames.

L'invention propose également un procédé de désentrelacement d'unités d'entrelacement entrelacées selon le procédé présenté ci-avant, pour un réseau de communication radio à entrelacement temporel de longue période.

Ce procédé de désentrelacement se caractérise par le fait qu'il consiste à synchroniser le dèsentrelacement par rapport à l'entrelacement, et, en cas de sélection d'un groupe de services à désentrelacer, à travailler périodiquement pendant au moins la durée de chaque intervalle temporel d'étalement du groupe sélectionné, et donc selon une période égale à la période des trames, afin de collecter toutes les unités d'entrelacement entrelacées contenues dans les intervalles temporels d'étalement du groupe sélectionné compris dans une période correspondant à une période de l'entrelacement temporel, en vue d'un desentrelacement.

Ce procédé de désentrelacement selon l'invention peut comporter d'autres caractéristiques qui peuvent être prises séparément ou en combinaison, et notamment :
- lors de chaque période correspondant à une période de l'entrelacement temporel, on peut stocker toutes les unités d'entrelacement entrelacées contenues dans les intervalles temporels d'étalement du groupe sélectionné qui sont compris dans la période en cours de l'entrelacement temporel, et à la fin de cette période en cours de l'entrelacement temporel on procède au désentrelacement des unités d'entrelacement entrelacées stockées, puis à leur filtrage ;
- en variante, on peut retenir parmi les unités d'entrelacement entrelacées qui ont été collectées celles qui représentent les services du groupe sélectionné ;
- lors de chaque période correspondant à une période de l'entrelacement temporel, on peut stocker les unités d'entrelacement entrelacées retenues dans les intervalles temporels d'étalement du groupe sélectionné qui sont compris dans la période en cours correspondant à une période de l'entrelacement temporel, et à la fin de cette période en cours (correspondant à une période de l'entrelacement temporel) on procède au filtrage des unités d'entrelacement entrelacées stockées, puis à leur désentrelacement.

L'invention propose enfin un programme d'ordinateur chargeable dans une mémoire associée à un processeur, et comprenant des instructions pour la mise en oeuvre d'un procédé tel que défini ci-dessus lors de l'exécution dudit programme par le processeur, ainsi qu'un support informatique sur lequel est enregistré ledit programme.

D'autres caractéristiques et avantages de l'invention apparaîtront à l'examen de la description détaillée ci-après, et des dessins annexés, sur lesquels:

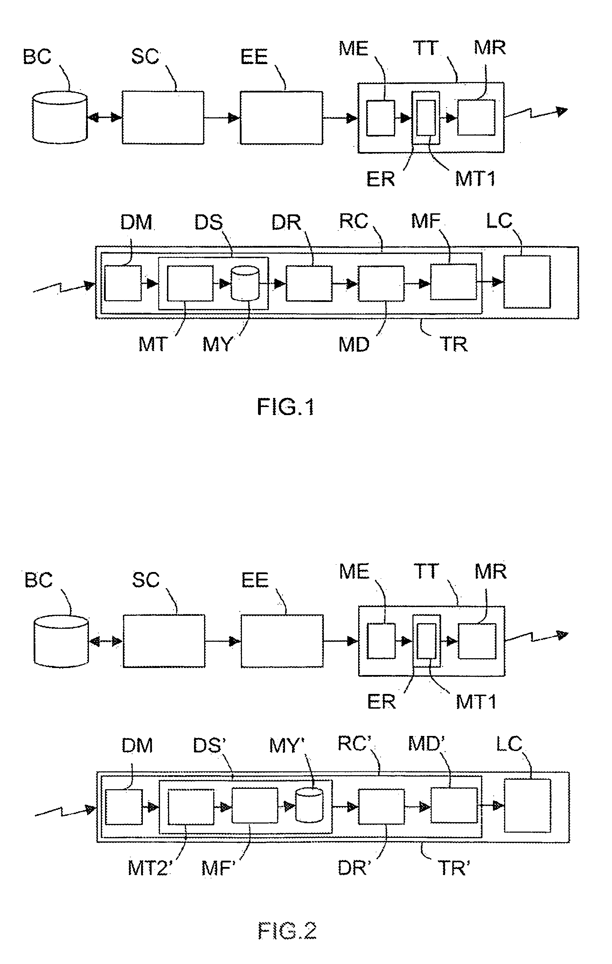

- la figure 1 illustre de façon très schématique et fonctionnelle une chaîne de transmission de contenus multimédia comprenant un exemple de réalisation d'un entrelaceur selon l'invention et un premier terminal récepteur de contenus multimédia incluant un premier exemple de réalisation d'un dispositif de sélection de services selon l'invention,
- la figure 2 illustre de façon très schématique et fonctionnelle une chaîne de transmission de contenus multimédia comprenant un exemple de réalisation d'un entrelaceur selon l'invention et un second terminal récepteur de contenus multimédia incluant un second exemple de réalisation d'un dispositif de sélection de services selon l'invention,

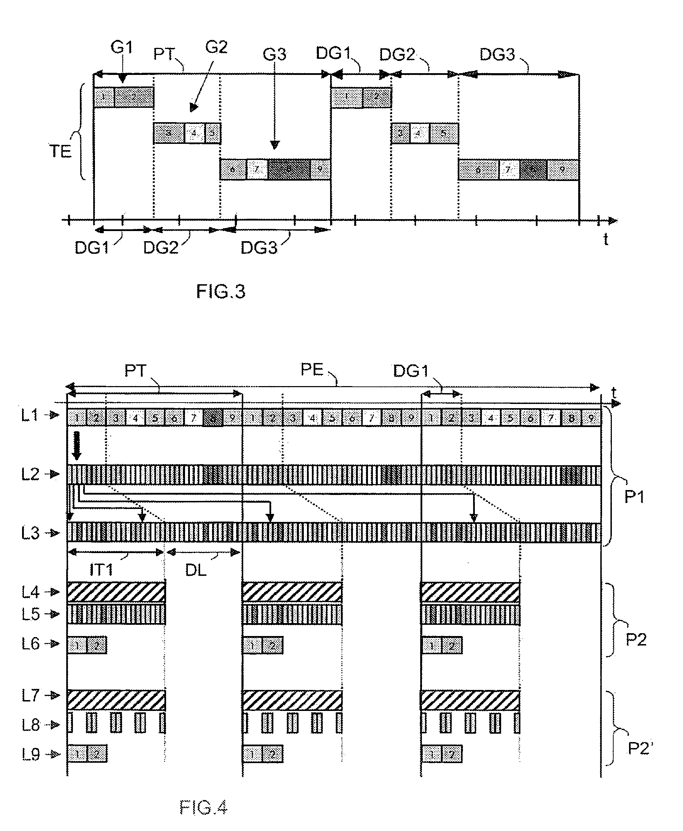

- la figure 3 illustre de façon très schématique la décomposition dans le temps (t) de deux trames de rafales successives en trois groupes de services comportant respectivement deux, trois et quatre services, et
- la figure 4 illustre de façon très schématique, d'une première part, les conséquences sur des trames (de neuf rafales successives) de la mise en oeuvre des principales étapes d'un procédé d'entrelacement selon l'invention, d'une deuxième part, les conséquences sur les unités d'entrelacement entrelacées au moyen du procédé d'entrelacement selon l'invention de la mise en oeuvre des principales étapes d'un premier procédé de désentrelacement selon l'invention et du filtrage de services consécutif, et d'une troisième part, les conséquences sur les unités d'entrelacement entrelacées au moyen du procédé d'entrelacement selon l'invention de la mise en oeuvre des principales étapes d'un second procédé de désentrelacement selon l'invention, incorporant un filtrage de services. L'axe référencé t matérialise le temps.

Les dessins annexés pourront non seulement servir à compléter l'invention, mais aussi contribuer à sa définition, le cas échéant.

L'invention a pour objet de permettre la transmission de contenus multimédia à des terminaux récepteurs via un réseau de communication radio mettant en oeuvre un entrelacement (ou interleaving) temporel de longue durée au niveau de la couche physique.

Dans ce qui suit, on considère à titre d'exemple non limitatif que le réseau de communication radio est un réseau de type DVB-SH, par exemple destiné à diffuser des programmes de télévision à destination de terminaux récepteurs mobiles (ou cellulaires), tels que des téléphones mobiles, au moyen de satellite(s) et éventuellement de relais terrestres. Mais l'invention n'est limitée ni à ce type de réseau de communication radio, ni à ce type de terminal récepteur, ni à ce type de contenus multimédia.

L'invention concerne en effet tout type de réseau de communication radio mettant en oeuvre un entrelacement temporel de longue durée au niveau de la couche physique et susceptible de faire l'objet d'évanouissements importants des signaux, et notamment les réseaux de type SDR (satellite Digital Radio) et DVB-SH.

Par tailleurs, l'invention concerne tout type de terminal de communication radio équipé d'un récepteur radio de contenus multimédia ayant fait l'objet d'un entrelacement temporel de longue durée au niveau de la couche physique. Par conséquent, elle concerne notamment les ordinateurs fixes ou portables et les assistants numériques personnels (ou PDAs) à module de communication par voie d'ondes, les serveurs équipés d'un éventuel lecteur de contenus multimédia, et tout type de récepteur de contenus multimédia raccordable à un réseau radio de diffusion et destiné à alimenter en contenus multimédia diffusés un lecteur de contenus multimédia ou des moyens de stockage.

Enfin, l'invention concerne tout type de contenu multimedia constitué d'un ensemble de données d'un même type, et notamment les programmes de radio, les fichiers de données (ou data) et les vidéos.

On a représenté sur la figure 1 une chaîne de transmission (diffusion) de contenus multimédia entre un serveur de contenus multimédia SC et des terminaux récepteurs TR comportant un (ou se présentant sous la forme d'un) récepteur de contenus multimédia RC, via un équipement d'encapsulation IP EE. un terminal de transmission TT et un réseau de diffusion (non représenté et ici de type DVB-SH).

Il est rappelé qu'un serveur de contenus multimédia (ou encodeur vidéo) SC est chargé de transformer en ensembles de données des contenus multimédia, par exemple issus d'une base de données de contenus BC, puis d'intégrer ces ensembles de données dans des paquets IP, afin de délivrer en sortie des flux continus de paquets IP qui sont destinés à un équipement d'encapsulation IP EE.

L'équipement d'encapsulation IP (ou IPE pour «IP Encapsulator ») EE est chargé d'encapsuler les paquets IP reçus dans des rafales (ou bursts) conformément au mode de transmission qui est utilisé par le réseau de diffusion utilisé. Ce mode de transmission est par exemple TDMA (Time Division Multiple Access - multiplexage temporel).

On entend ici par « rafale » un ensemble de paquets, par exemple au format MPEG, constituant un ou plusieurs services et définissant une partie d'un ou plusieurs contenus multimédia (ici des programmes de télévision).

Les rafales (ici TDMA) sont communiquées par l'équipement d'encapsulation IP EE à un terminal de transmission TT du réseau de diffusion afin qu'il les diffuse (après traitement) vers les terminaux récepteurs TR. Les tailles des rafales associées aux différents services ne sont pas forcément constantes dans le temps. Par contre, les rafales associées respectivement aux différents services sont ordonnées au sein de trames TE périodiques, de période PT, comme illustré sur la première ligne (L1) de la figure 4 dans le cas de neuf services.

Un terminal de transmission TT comprend habituellement au moins un module d'encodage ME, un entrelaceur (ou « interleaver ») temporel ER et un modulateur MR.

Le module d'encodage ME est chargé d'appliquer aux constituants des rafales (généralement appelés unités d'entrelacement (ou IUs pour « Interleaving Units ») par l'homme de l'art) une technique de correction d'erreur (insertion de redondance) de type FEC ainsi qu'en plus (éventuellement) MPE-FEC, afin de délivrer des unités d'entrelacement toujours regroupées entre elles en fonction des rafales auxquelles elles appartiennent, comme illustré sur la deuxième ligne (L2) de la figure 4.

L'entrelaceur temporel ER, selon l'invention, reçoit les unités d'entrelacement (qui représentent un nombre choisi de services regroupés dans des trames périodiques TE) et comprend un module de traitement MT1 chargé tout d'abord de décomposer chaque trame TE en un nombre entier choisi de groupes de service(s) Gi de durées DGi respectives constantes.

On notera que même si c'est in fine le modulateur qui fait la segmentation, cette dernière peut/doit lui être signalée par l'encapsulateur qui, lui, connaît la délinéation des services, ce qui n'est pas le cas du modulateur qui fonctionne généralement à des niveaux beaucoup plus bas.

Il est important de noter que le nombre de groupes Gi est compris entre un et le nombre N de services (ou rafales) d'une trame TE. En d'autres termes l'indice i est compris entre 1 et N. Par conséquent, le nombre de services (ou rafales) d'un groupe peut être compris entre 1 et N. On a représenté sur la figure 3 un exemple dans lequel le module de traitement MT1 décompose chaque trame périodique TE, de période PT. en trois groupes G1 à G3 (i = 1 à 3), le premier groupe G1 comprenant les deux services numérotés 1 et 2, le deuxième groupe G2 comprenant les trois services numérotés 3 à 5, et le troisième groupe G3 comprenant les quatre services numérotés 6 à 9.

Comme on peut le constater dans l'exemple non limitatif de la figure 3, la durée temporelle DGi d'un groupe Gi est constante de trame TE en trame TE. En d'autres termes, la somme des durées temporelles des services qui composent un groupe Gi d'une trame TE est constante de trame TE en trame TE, mais les durées temporelles respectives des services qui composent un groupe Gi peuvent varier d'une trame TE à l'autre. On notera que ces durées temporelles peuvent être éventuellement changées par reconfiguration.

On notera qu'il est préférable que les unités d'entrelacement de chaque groupe Gi soient réparties dans des intervalles temporels d'étalement ITi dont les durées Dli respectives sont petites par rapport à la période PT des trames TE. En d'autres termes, la durée DL qui sépare la fin d'un intervalle temporel d'étalement ITi (par exemple IT1) du début de l'intervalle temporel d'étalement ITi suivant, laquelle est égale à la somme des durées Dli' (i') des autres intervalles temporels d'étalement ITi' compris dans une période PT, est de préférence petite par rapport à la durée Dl1 de l'intervalle temporel d'étalement ITi.

On notera également que pour faciliter la compréhension de l'invention, la durée Dl1 de l'intervalle temporel d'étalement IT1 a été volontairement grossie et est donc disproportionnée par rapport à la durée DL représentée.

On notera également que le module de traitement MT1 doit être parfaitement synchronisé sur l'équipement d'encapsulation IP EE, afin que la couche de services et la couche physique soient synchronisées. La synchronisation est de préférence assurée au moyen d'informations de synchronisation qui sont transmises avec la signalisation (mais, en variante, le module de traitement MT1 pourrait découvrir la configuration par ses propres moyens). En fait, il s'agit de signaler l'arrivée de certaines fractions de trames TE de manière à permettre le calage de l'entrelaceur ER par rapport à ces fractions de trames TE.

Une fois les groupes Gi d'une trame TE constitués, le module de traitement MT1 répartit (ou entrelace) les unités d'entrelacement de chaque groupe Gi dans des intervalles temporels dits d'étalement ITi, dont les durées DIi respectives sont constantes et qui sont espacés périodiquement au sein d'une période PE de l'entrelacement temporel selon une période PI qui est égale à la période PT des trames TE. En d'autres terme, si chaque trame périodique TE est décomposée en trois groupes G1 à G3 de durées respectives DGi constantes, et que la période PE de l'entrelacement temporel est égal à MxPT, alors les unités d'entrelacement du premier groupe G1 sont réparties dans M intervalles temporels d'étalement IT1 de durée constante DI1 et espacés périodiquement d'une période PI (égale à PT), les unités d'entrelacement du deuxième groupe G2 sont réparties dans M intervalles temporels d'étalement IT2 de durée constante DI2 et espacés périodiquement d'une période PI (égale à PT), et les unités d'entrelacement du troisième groupe G3 sont réparties dans M intervalles temporels d'étalement IT3 de durée constante DI3 et espacés périodiquement d'une période PI (égale à PT).

On a représenté à la troisième ligne (L3) de la figure 4 un exemple non limitatif de répartition des unités d'entrelacement du premier groupe G1 (constitué des services 1 et 2) d'une trame TE dans M=3 intervalles temporels d'étalement IT1 de durée constante DI1 et espacés périodiquement d'une période PI (égale à PT) au sein d'une période PE d'un entrelacement temporel.

Toute technique d'entrelacement déterministe connue de l'homme de l'art peut être utilisée, et notamment celle dite convolutive et celle dite par blocs.

Une fois que le module de traitement MT1 à réparti (ou entrelacé) les unités d'entrelacement d'une trame TE au sein d'une période PE d'un entrelacement temporel, le procédé d'entrelacement P1 (dont les conséquences sont schématiquement représentées sur les trois premières lignes (L1 à L3) de la figure 4) est terminé pour cette trame TE. Le module de traitement MT1 communique les unités d'entrelacement entrelacées au modulateur MR afin qu'il leur applique une modulation choisie, par exemple QPSK ou 16QAM, avant qu'elles ne soient transmises (diffusées) par voie d'ondes à destination de terminaux récepteurs TR (ou TR').

On notera que l'entrelaceur ER selon l'invention peut être réalisé sous la forme de circuits électroniques, de modules logiciels (ou informatiques), ou d'une combinaison de circuits et de logiciels.

Comme cela est illustré sur les deux exemples de réalisation des figures 1 et 2. un terminal récepteur TR (ou TR') comprend un récepteur de contenus RC (ou RC') qui alimente éventuellement un lecteur de contenus LC ou bien des moyens de mémorisation (non représentés), comme par exemple un disque dur ou une base de données.

Le récepteur de contenus RC comprend tout d'abord un démodulateur DM chargé de démoduler les unités d'entrelacement entrelacées et modulées, selon la technique de modulation utilisée par le modulateur MR du terminal de transmission TT. La sortie de ce démodulateur DR alimente l'entrée d'un dispositif de sélection de services DS (ou DS') selon l'invention.

Un dispositif de sélection de services DS (ou DS') comprend au moins un module de traitement MT2 (ou MT2') qui est synchronisé par rapport à l'horloge de l'entrelaceur ER utilisé pour entrelacer les unités d'entrelacement.

La synchronisation est assurée au moyen d'informations de synchronisation (ou de localisation de services) qui sont transmises avec la signalisation, laquelle fait de préférence l'objet de l'entrelacement temporel. Les informations de synchronisation définissant au moins la durée d'une période PE de l'entrelacement temporel, la durée d'une trame TE, les durées Dli respectives des intervalles temporels d'étalement ITi et le début de la première unité d'entrelacement entrelacée de la prochaine période PE, le module de traitement MT2 peut donc facilement se synchroniser sur le début de la prochaine période PE, et déterminer le début du premier intervalle temporel d'étalement ITi du groupe Gi sélectionné (contenu dans cette prochaine période PE) par rapport au début de la prochaine période PE.

Le module de traitement MT2 (ou MT2') est chargé, lorsqu'un groupe Gi de service(s) à été localement sélectionné afin d'être stocké ou utilisé au moins partiellement, de se mettre en fonctionnement (« mode ON ») périodiquement pendant au moins la durée Dli de chaque intervalle temporel d'étalement ITi du groupe Gi sélectionné, et donc selon une période égale à la période PT des trames TE initiales (avant entrelacement). Cela permet d'économiser la batterie.

En d'autres termes, le module de traitement MT2 (ou MT2') n'est mis en fonctionnement (activé) que périodiquement afin de ne collecter que les unités d'entrelacement entrelacées qui sont comprises dans chaque intervalle temporel d'étalement ITi du groupe Gi sélectionné. On notera qu'en régime permanent le décodeur fonctionne également sur des unités d'entrelacement qui ont été préalablement stockées. Ainsi, lors de chaque période PE de l'entrelacement temporel il collecte toutes les unités d'entrelacement entrelacées contenues dans les intervalles temporels d'étalement ITi du groupe Gi sélectionné compris dans ladite période PE.

Cela est particulièrement avantageux car cela réduit très notablement la quantité d'unités d'entrelacement qui doivent être collectées par le module de traitement MT2 (ou MT2') lors de chaque période PE de l'entrelacement temporel afin de pouvoir être désentrelacées.

On a schématiquement matérialisé par des rectangles hachurés sur les quatrième (L4) et septième lignes (L7) de la figure 4 les phases de fonctionnement du module de traitement MT2 lorsque le groupe de services sélectionné est G1 (lequel correspond aux intervalles temporels d'étalement IT1. Ici la durée de fonctionnement est sensiblement identique à la durée DG1 de chaque intervalle temporel d'étalement IT1. Mais, comme indiqué précédemment, cette durée de fonctionnement pourrait être plus longue en débutant légèrement avant le début de chaque intervalle temporel d'étalement IT1 et/ou en se terminant légèrement après la fin de chaque intervalle temporel d'étalement IT1.

On comprendra aisément en se reportant à la cinquième ligne (L5) de la figure 4, que les unités d'entrelacement entrelacées, qui sont collectées par le module de traitement MT2 (ou MT2') dans chaque intervalle temporel d'étalement ITi du groupe Gi sélectionné, n'appartiennent pas exclusivement, généralement, au(x) service(s) du groupe Gi sélectionné. Elles sont en effet entrelacées avec des unités d'entrelacement appartenant à des services d'autres groupes Gi' (i'). Par conséquent deux modes de réalisation différents peuvent être envisagés pour le dispositif DS (ou DS').

Dans un premier mode de réalisation, illustré sur la figure 1, le dispositif DS comprend par exemple une mémoire MY dans laquelle son module de traitement MT2 stocke lors de chaque période PE de l'entrelacement temporel toutes les unités d'entrelacement entrelacées qui sont contenues dans les intervalles temporels d'étalement ITi du groupe Gi sélectionné qui sont compris dans la période PE en cours de l'entrelacement temporel, sans filtrage. Cela permet déjà de réduire notablement la capacité de stockage de la mémoire MY comparée à celle qui est nécessaire dans un récepteur de contenus de l'art antérieur.

A la fin de chaque période PE d'entrelacement temporel le désentrelaceur DR extrait (ou reçoit) de la mémoire MY les unités d'entrelacement entrelacées qui ont été collectées et stockées pendant la période PE écoulée, afin de procéder à leur désentrelacement. La technique de désentrelacement qui est ici utilisée est l'inverse de celle utilisée pour l'entrelacement dans l'entrelaceur ER. Elle est par exemple convolutive ou par blocs.

Les unités d'entrelacement (désentrelacées) alimentent alors un module de désencodage MD qui est chargé de leur appliquer une technique inverse de la technique de correction d'erreur qui est utilisée par le module d'encodage ME. Elle est par exemple de type FEC ainsi qu'en plus (éventuellement) MPE-FEC.

Les unités d'entrelacement désencodées et désentrelacées alimentent alors un module de filtrage MF qui est chargé de sélectionner exclusivement celles qui définissent le(s) service(s) du groupe Gi sélectionné, et ainsi de reconstituer les rafales (ou services) initialement contenue(s) dans les M trames TE contenues dans une période PE de l'entrelacement temporel. On a schématiquement représenté sur la sixième ligne (L6) de la figure 4 les deux rafales (ou services 1 et 2) du premier groupe de services G1 qui étaient initialement contenues dans les trois trames TE correspondant à une période PE de l'entrelacement temporel.

On notera que les quatrième (L4) à sixième (L6) lignes de la figure 4 matérialisent les conséquences sur les unités d'entrelacement entrelacées de l'application du premier procédé de désentrelacement P2 qui est mis en oeuvre par un récepteur de contenus RC du type de celui illustré sur la figure 1.

Une fois que les rafales (ou services) du groupe Gi sélectionné ont été reconstituées, elles peuvent alors être stockées ou utilisées (lues) par un lecteur de contenus LC, comme illustré sur la figure 1, non limitativement.

Dans un deuxième mode de réalisation, illustre sur la figure 2, le dispositif DS' comprend par exemple un module de filtrage MP en sortie du module de traitement MT2'. Ce module de filtrage MF' est donc chargé de retenir parmi les unités d'entrelacement, entrelacées et collectées par le module de traitement MT2', celles qui représentent les services du groupe Gi qui a été sélectionné.

Pour effectuer ce filtrage, le module de filtrage MF' doit disposer d'informations sur le type d'entrelacement déterministe effectué et sur les trames TE à vernir. Ces informations sont de préférence contenues dans la signalisation, comme les informations de synchronisation. Par exemple, si l'on signale au module de filtrage MF' le début de la première unité d'entrelacement du groupe de service(s) Gi sélectionné, il est alors capable, du fait de la connaissance de la fonction déterministe d'entrelacement utilisée, de déterminer les positions temporelles des autres unités d'entrelacement de ce groupe de service(s) Gi sélectionné.

Grâce à ce filtrage, le module de filtrage MF' délivre sur sa sortie uniquement les unités d'entrelacement entrelacées qui ont été collectées par le module de traitement MT2' dans chaque intervalle temporel d'étalement ITi du groupe Gi sélectionné. On a représenté à la huitième ligne (L8) de la figure 4, les unités d'entrelacement entrelacées filtrées par le module de filtrage MF dans chaque intervalle temporel d'étalement IT1 associé au premier groupe G1 sélectionné et contenu dans une période PE de l'entrelacement temporel.

Les unités d'entrelacement entrelacées et filtrées contenues dans une période PE de l'entrelacement temporel sont stockées au fur et à mesure de leur filtrage dans une mémoire MY'. Le nombre d'unités d'entrelacement à stocker pendant une période PE de l'entrelacement temporel est ainsi très notablement réduit, ce qui permet de réduire encore la capacité de stockage de la mémoire MY'.

A la fin de chaque période PE d'entrelacement temporel le desentrelaceur DR' extrait (ou reçoit) de la mémoire MY' les unités d'entrelacement entrelacées et filtrées qui ont été collectées, filtrées et stockées pendant la période PE écoulée, afin de procéder à leur désentrelacement. La technique de désentrelacement qui est ici utilisée est l'inverse de celle utilisée pour l'entrelacement dans l'entrelaceur ER, mais restreinte aux seules unités d'entrelacement du groupe Gi sélectionné, ce qui facilite son application et permet de réduir les capacités de calcul nécessaires.

Les unités d'entrelacement (filtrées et désentrelacées) alimentent alors un module de désencodage MD' qui est chargé de leur appliquer une technique inverse de la technique de correction d'erreur qui est utilisée par le module d'encodage ME. Elle est par exemple de type FEC ainsi qu'en plus (éventuellement) MPE-FEC.

Ensuite, le module de désencodage MD' reconstitue les rafales (ou services) initialement contenue(s) dans les M trames TE contenues dans une période PE de l'entrelacement temporel avec les unités d'entrelacement filtrées, désencodées et désentrelacées.

On a schématiquement représenté sur la neuvième ligne (L9) de la figure 4 les deux rafales (ou services 1 et 2) du premier groupe de services G1 qui étaient initialement contenues dans les trois (M=3) trames TE d'une période PE de l'entrelacement temporel.

On notera que les septième (L7) à neuvième (L9) lignes de la figure 4 matérialisent les conséquences sur tes unités d'entrelacement entrelacées de l'application du second procédé de désentrelacement P2' qui est mis en oeuvre par un récepteur de contenus RC' du type de celui illustré sur la figure 2.

Une fois que les rafales (ou services) du groupe Gi sélectionné ont été reconstituées, elles peuvent alors être stockées ou utilisées (lues) par un lecteur de contenus LC, comme illustré sur la figure 1 non limitativement.

On notera que les informations de synchronisation et les éventuelles informations sur le type d'entrelacement déterministe effectué et sur les trames TE à venir peuvent par exemple être transmises dans ce que l'home de l'art appelle des entêtes de trame SF (ou « Signalling Field ») dans le cas d'un fonctionnement dans le mode TDM ou dans le numéro désignant une super trame (ou « super trame number ») en TPS dans le cas d'un fonctionnement dans le mode OFDM, ou encore dans le SHIP (« SH frame initialization Racket »).

Les dispositifs de sélection de services DS et DS' selon l'invention peuvent être réalisés sous la forme de circuits électroniques, de modules logiciels (ou informatiques), ou d'une combinaison de circuits et de logiciels.

L'invention ne se limite pas aux modes de réalisation d'entrelaceur, de dispositif de sélection de services, de procédé d'entrelacement et de procédé de désentrelacement décrits ci-avant, seulement à titre d'exemple, mais elle englobe toutes les variantes que pourra énvisager l'homme de l'art dans le cadre des revendications ci-après.

## Revendications

1. Entreiaceur (ER) d'unités d'entrelacement représentant un nombre choisi de services regroupés dans des trames périodiques (PT), pour un réseau de communication radio à entrelacement temporel de longue période (PE), **caractérisé en ce qu'**il comprend des moyens de traitement (MT1) agencés pour décomposer chaque trame en un nombre choisi de groupes de service(s) (Gi) de durées (DGi) respectives constantes, puis pour répartir les unités d'entrelacement de chaque groupe (Gi) dans des intervalles temporels dits d'étalement (ITi) de durées (Dli) respectives constantes et espacés au sein d'une période (PE) de l'entrelacement temporel selon une période (PI) égale à la période (PT) des trames.

2. Entrelaceur (ER) selon la revendication 1, **caractérisé en ce que** lesdits moyens de traitement (MT1) sont agencés pour répartir les unités d'entrelacement de chaque groupe (Gi) dans des intervalles temporels d'étalement (ITi) de durées (Dli) respectives constantes et petites par rapport à ladite période (PT) des trames.

3. Dispositif (DS ;DS') de sélection de services représentés par des unités d'entrelacement entrelacées au moyen d'un entrelacer (ER) selon l'une des revendications 1 et 2, pour un réseau de communication radio à entrelacement temporel de longue période (PE), **caractérisé en ce qu'**il comprend des moyens de traitement (MT2 MT2') synchronisés par rapport audit entrelaceur (ER) et agencés, en cas de sélection d'un groupe (Gi) de services à traiter, pour se mettre en fonctionnement périodiquement pendant au moins la durée (Dli) de chaque intervalle temporel d'étalement (ITi) dudit groupe (Gi) sélectionné, et donc selon une période égale à la période (PT) des trames (TE), de manière à collecter toutes les unités d'entrelacement entrelacées contenues dans les intervalles temporels d'étalement (ITi) du groupe (Gi) sélectionné compris dans une période (PE) de l'entrelacement temporel.

4. Dispositif selon la revendication 3, **caractérisé en ce qu'**il comprend des moyens de mémorisation (MY) propres à stocker des unités d'entrelacement entrelacées, et **en ce que** lesdits moyens de traitement (MT2) sont agencés pour stocker dans lesdits moyens de mémorisation (MY), lors de chaque période (PE) de l'entrelacement temporel, toutes les unités d'entrelacement entrelacées contenues dans les intervalles temporels d'étalement (ITi) du groupe (Gi) sélectionné qui sont compris dans la période (PE) en cours de l'entrelacement temporel.

5. Dispositif selon la revendication 3, **caractérisé en ce qu'**il comprend des moyens de filtrage (MF') agencés pour retenir parmi les unités d'entrelacement entrelacées et. collectées celles qui représentent les services du groupe (Gi) sélectionné.

6. Dispositif selon la revendication 5, **caractérisé en ce qu'**il comprend des moyens de mémorisation (MY') propres à stocker des unités d'entrelacement entrelacées, et **en ce que** lesdits moyens de filtrage (MF') sont agencés pour stocker dans lesdits moyens de mémorisation (MY'), lors de chaque période (PE) de l'entrelacement temporel, les unités d'entrelacement entrelacées retenues dans les intervalles temporels d'étalement (ITi) du groupe (Gi) sélectionné qui sont compris dans la période (PE) en cours de l'entrelacement temporel.

7. Procédé d'entrelacement d'unités d'entrelacement représentant un nombre choisi de services regroupés dans des trames de période (PT), pour un réseau de communication radio à entrelacement temporel de longue période (PE), **caractérisé en ce qu'**il consiste à décomposer chaque trame en un nombre choisi de groupes de service(s) (Gi) de durées (DGi) respectives constantes, puis à répartir les unités d'entrelacement de chaque groupe (Gi) dans des intervalles temporels dits d'étalement (ITi) de durées (Dli) respectives constantes et espacés au sein d'une période (PE) de l'entrelacement temporel selon une période (Pl) égale à la période (PT) des trames.

8. Procédé de désentrelacement d'unités d'entrelacement entrelacées selon la revendication 7, pour un réseau de communication radio à entrelacement temporel de longue période (PE), **caractérisé en ce qu'**il consiste à synchroniser le désentrelacement par rapport audit entrelacement, et en cas de selection d'un groupe (Gi) de services à désentrelacer, à travailler périodiquement pendant au moins la durée (DH) de chaque intervalle temporel d'étalement (ITi) dudit groupe (Gi) sélectionné, et donc selon une période égale à la période (PT des trames, de manière à collecter toutes les unités d'entrelacement entrelacées contenues dans les intervalles temporels d'étalement (ITi) du groupe (Gi) sélectionne compris dans une période correspondant à une période (PE) de l'entrelacement temporel, en vue d'un désentrelacement.

9. Procédé selon la revendication 8, **caractérisé en ce que** l'on stocke lors de chaque période (PE) de l'entrelacement temporel toutes les unités d'entrelacement entrelacées contenues dans les intervalles temporels d'étalement (ITi) du groupe (Gi) sélectionné qui sont compris dans la période en cours correspondant à une période (PE) de l'entrelacement temporel, et à la fin de ladite période PE) en cours de l'entrelacement temporel on procède au désentrelacement des unités d'entrelacement entrelacées et stockées, puis à leur filtrage:

10. Procédé selon la revendication 8, **caractérisé en ce que** l'on retient parmi les .unités d'entrelacement collectées celles qui représentent les services du groupe (Gi) sélectionné.

11. Procédé selon la revendication 10, **caractérisé en ce que** l'on stocke lors de chaque période correspondant à une période (PE) de l'entrelacement temporel les unités d'entrelacement entrelacées retenues dans les intervalles temporels d'étalement (ITi) du groupe (Gi) sélectionné qui sont compris dans là période en cours correspondant à une période (PE) de l'entrelacement temporel, et à la fin de ladite période en cours correspondant à une période (PE) de l'entrelacement temporel on procède au filtrage des unités d'entrelacement entrelacées et stockées, puis à leur désentrelacement.

12. Programme d'ordinateur, chargeable dans une mémoire associée à un processeur, et comprenant des instructions pour la mise en oeuvre d'un procédé selon l'une quelconque des revendications 7 à 11 lors de l'exécution dudit programme par le processeur.

13. Support informatique sur lequel est enregistré un programme selon la revendication 12.

## Claims

1. An interleaver (ER) of interleaving units representing a chosen number of services grouped into periodic frames (PT), for a long-period time-interleaving radio communication network (PE), **characterized in that** it comprises processing means (MT1) adapted for dividing each frame into a chosen number of groups of service(s) (Gi) with respective constant durations (DGi), then for distributing the interleaving units of each group (Gi) into so-called spreading time intervals (ITi) with respective constant durations (Dli) and spaced within a time-interleaving period (PE) at a period (PI) equal to the period (PT) of the frames.

2. An interleaver (ER) according to claim 1, **characterized in that** said processing means (MT1) are adapted for distributing the interleaving units of each group (Gi) into spreading time intervals (ITi) with respective constant durations (Dli) which are short compared to said period (PT) of the frames.

3. A device (DS; DS') for selecting services represented by interleaving units interleaved by means of an interleaver (ER) according to one of the claims 1 and 2, for a long-period time-interleaving radio communication network (PE), **characterized in that** it comprises processing means (MT2; MT2') synchronized to said interleaver (ER) and adapted for, in case of selection of a group of services (Gi) to be processed, periodically entering operation for at least the duration (Dli) of each spreading time interval (ITi) of said selected group (Gi), and therefore at a period equal to the period (PT) of the frames (TE) so as to collect all the interleaved interleaving units contained within the spreading time intervals (ITi) of the selected group (Gi) comprised within a time interleaving period (PE).

4. A device according to claim 3, **characterized in that** it comprises memorization means (MY) capable of storing interleaved interleaving units and **in that** said processing means (MT2) are configured to store within said memorization means (MY), during each time interleaving period (PE), all of the interleaved interleaving units contained within the spreading time intervals (Fi) of the selected group (Gi) which are comprised within the period (PE) undergoing time interleaving.

5. A device according to claim 3, **characterized in that** it comprises filtering means (ME) adapted for retaining from among the interleaved and collected interleaving units those which represent the services of the selected group (Gi).

6. A device according to claim 5, **characterized in that** it comprises memorization means (MY') capable of storing interleaved interleaving units, and **in that** said filtering means (ME') are configured to store within said memorization means (MY'), during each time interleaving period (PE), the interleaved interleaving units retained in the spread time intervals (ITi) of the selected group (Gi) which are comprised within the period (PE) undergoing time interleaving.

7. A method for interleaving interleaving units representing a chosen number of services grouped into periodic frames (PT), for a long-period time-interleaving radio communication network (PE), **characterized in that** it consists of dividing each frame into a chosen number of groups of service(s) (Gi) with respective constant durations (DGi), then distributing the interleaving units of each group (Gi) into so-called spread time intervals (ITi) with respective constant durations (Dli) spaced within a time-interleaving period (PE) at a period (PI) equal to the period (PT) of the frames.

8. A method for de-interleaving interleaving units interleaved according to claim 7, for a long-period time-interleaving radio communication network (PE), **characterized in that** it consists of synchronizing the de-interleaving to said interleaving, and, in case a group of services (Gi) to be de-interleaved is selected, of periodically working during at least the duration (Dli) of each spreading time interval (ITi) of said selected group (Gi), and therefore at a period equal to the period (PT) of the frames, so as to collect all of the interleaved interleaving units contained within the spreading time intervals (ITi) of the selected group comprised within the period corresponding to a time interleaving period (PE), in view of a de-interleaving.

9. A method according to claim 8, **characterized in that** during each time interleaving period (PE), all of the interleaved interleaving units contained within the spread time intervals (ITi) of the selected group (Gi) which are comprised within the current period corresponding to a time interleaving period (PE) are stored, and at the end of said current time interleaving period (PE), the interleaved and stored interleaving units are de-interleaved, and then filtered.

10. A method according to claim 8, **characterized in that** among the collected interleaving units, the ones which represent the services of the selected group (Gi) are retained.

11. A method according to claim 10, **characterized in that** during each period corresponding to a time interleaving period (PE), the interleaved interleaving units retained in the spread time intervals (ITi) of the selected group (Gi) which are included in the current period corresponding to a time interleaving period (PE) are stored, and at the end of said current period corresponding to a time interleaving period (PE), the interleaved interleaving and stored units are filtered, then de-interleaved.

12. A computer program, which may be loaded into a memory associated with a processor, comprising instructions for implementing a method according to any one of the claims 7 to 11 when said program is executed by the processor.

13. A data-processing medium on which is recorded a program according to claim 12.

## Patentansprüche

1. Verschachteler (ER) für Verschachtelungseinheiten, welche eine ausgewählte Anzahl von in periodischen Rahmen (PT) gruppierten Diensten darstellen, für ein Funkkommunikationsnetzwerk mit Zeitverschachtelung von langer Zeitdauer (PE), **dadurch gekennzeichnet, dass** er Verarbeitungsmittel (MT1) umfasst, welche dazu ausgelegt sind, jeden Rahmen in eine ausgewählte Anzahl von Dienstgruppen (Gi) mit jeweiligen konstanten Dauern (DGi) zu zerlegen und anschließend die Verschachtelungseinheiten einer jeden Gruppe (Gi) in sogenannten Ausbreitungs-Zeitintervallen (ITi) mit jeweiligen konstanten und voneinander beabstandeten Dauern (Dli) innerhalb einer Zeitdauer (PE) der Zeitverschachtelung gemäß einer Dauer (PI), welche der Dauer (PT) der Rahmen entspricht, zu verteilen.

2. Verschachteler (ER) nach Anspruch 1, **dadurch gekennzeichnet, dass** die besagten Verarbeitungsmittel (MT1) dazu ausgelegt sind, die Verschachtelungseinheiten einer jeden Gruppe (Gi) in Ausbreitungs-Zeitintervallen (ITi) mit jeweiligen konstanten und im Verhältnis zur besagten Zeitdauer (PT) der Rahmen kurzen Dauern (Dli) zu verteilen.

3. Vorrichtung (DS; DS') zur Auswahl von Diensten, welche von anhand eines Verschachtelers (ER) nach einem der Ansprüche 1 und 2 verschachtelten Verschachtelungseinheiten dargestellt werden, für ein Funkkommunikationsnetzwerk mit Zeitverschachtelung von langer Zeitdauer (PE), **dadurch gekennzeichnet, dass** sie Verarbeitungsmittel (MT2; MT2') umfasst, welche im Verhältnis zu dem besagten Verschachteler (ER) synchronisiert und dazu ausgelegt sind, sich im Fall der Auswahl einer Gruppe (Gi) von zu verarbeitenden Diensten periodisch für mindestens die Dauer (Dli) eines jeden Ausbreitungs-Zeitintervalls (ITi) der besagten ausgewählten Gruppe (Gi), und folglich gemäß einer Zeitdauer, welche der Zeitdauer (PT) der Rahmen (TE) entspricht, in Betrieb zu setzen, um alle verschachtelten Verschachtelungseinheiten, welche während einer Zeitdauer (PE) der Zeitverschachtelung in den Ausbreitungs-Zeitintervallen (ITi) der ausgewählten Gruppe (Gi) enthalten sind, zu sammeln.

4. Vorrichtung nach Anspruch 3, **dadurch gekennzeichnet, dass** sie Speichermittel (MY) umfasst, welche für das Speichern der verschachtelten Verschachtelungseinheiten ausgelegt sind, und dass die besagten Verarbeitungsmittel (MT2) dazu ausgelegt sind, während einer jeden Zeitdauer (PE) der Zeitverschachtelung alle verschachtelten Verschachtelungseinheiten, welche während der Zeitdauer (PE) der Zeitverschachtelung in den Ausbreitungs-Zeitintervallen (ITi) der ausgewählten Gruppe (Gi) enthalten sind, in den besagten Speichermitteln (MY) zu speichern.

5. Vorrichtung nach Anspruch 3, **dadurch gekennzeichnet, dass** sie Filtermittel (MF') umfasst, die dazu ausgelegt sind, unter den verschachtelten und gesammelten Verschachtelungseinheiten diejenigen zurückzuhalten, welche die Dienste der ausgewählten Gruppe (Gi) darstellen.

6. Vorrichtung nach Anspruch 5, **dadurch gekennzeichnet, dass** sie Speichermittel (MY') umfasst, welche für die Speicherung der verschachtelten Verschachtelungseinheiten ausgelegt sind, und dass die besagten Filtermittel (MF') dazu ausgelegt sind, während jeder Zeitdauer (PE) der Zeitverschachtelung die verschachtelten Verschachtelungseinheiten, welche während der Zeitdauer (PE) der Zeitverschachtelung in den Ausbreitungs-Zeitintervallen (ITi) der ausgewählten Gruppe (Gi) zurückgehalten wurden, in den besagten Speichermitteln (MY') zu speichern.

7. Verfahren zur Verschachtelung von Verschachtelungseinheiten, welche eine ausgewählte Anzahl von in Zeitdauerrahmen (PT) gruppierten Diensten darstellen, für ein Funkkommunikationsnetzwerk mit Zeitverschachtelung von langer Zeitdauer (PE), **dadurch gekennzeichnet, dass** es darin besteht, jeden Rahmen in eine ausgewählte Anzahl von Dienstgruppen (Gi) mit jeweiligen konstanten Dauern (DGi) zu zerlegen und anschließend die Verschachtelungseinheiten einer jeden Gruppe (Gi) in sogenannten Ausbreitungs-Zeitintervallen (ITi) von jeweiligen konstanten und voneinander beabstandeten Dauern (Dli) innerhalb einer Zeitdauer (PE) der Zeitverschachtelung gemäß einer Zeitdauer (PI), welche der Zeitdauer (PT) der Rahmen entspricht, zu verteilen.

8. Verfahren zur Entschachtelung von verschachtelten Verschachtelungseinheiten nach Anspruch 7 für ein Funkkommunikationsnetzwerk mit Zeitverschachtelung von langer Zeitdauer (PE), **dadurch gekennzeichnet, dass** es darin besteht, die Entschachtelung im Verhältnis zur besagten Verschachtelung zu synchronisieren und, im Fall der Auswahl einer Gruppe (Gi) von zu entschachtelnden Diensten, während mindestens der Dauer (Dli) eines jeden Ausbreitungs-Zeitintervalls (ITi) der besagten ausgewählten Gruppe (Gi) zu arbeiten, und folglich gemäß einer Zeitdauer, welche der Zeitdauer (PT) der Rahmen entspricht, zu arbeiten, um alle verschachtelten Verschachtelungseinheiten zu sammeln, die während einer Zeitdauer, welche einer Zeitdauer (PE) der Zeitverschachtelung entspricht, in den Ausbreitungs-Zeitintervallen (ITi) der ausgewählten Gruppe enthalten sind, um sie zu entschachteln.

9. Verfahren nach Anspruch 8, **dadurch gekennzeichnet, dass** alle verschachtelten Verschachtelungseinheiten, die während der momentanen Zeitdauer, welche einer Zeitdauer (PE) der Zeitverschachtelung entspricht, in den Ausbreitungs-Zeitintervallen (ITi) der ausgewählten Gruppe enthalten sind, während jeder Periode (PE) der Zeitverschachtelung gespeichert werden, und die verschachtelten und gespeicherten verschachtelten Verschachtelungseinheiten am Ende der besagten momentanen Zeitdauer (PE) der Zeitverschachtelung entschachtelt und anschließend gefiltert werden.

10. Verfahren nach Anspruch 8, **dadurch gekennzeichnet, dass** unter den gesammelten Verschachtelungseinheiten diejenigen zurückgehalten werden, welche die Dienste der ausgewählten Gruppe (Gi) darstellen.

11. Verfahren nach Anspruch 10, **dadurch gekennzeichnet, dass** während der momentanen Zeitdauer, welche einer Zeitdauer (PE) der Zeitverschachtelung entspricht, die in den Ausbreitungs-Zeitintervallen (ITi) der ausgewählten Gruppe (Gi) zurückgehaltenen verschachtelten Verschachtelungseinheiten während einer jeden Zeitdauer, welche einer Zeitdauer der Zeitdauer (PE) der Zeitverschachtelung entspricht, gespeichert werden und die verschachtelten und gespeicherten Verschachtelungseinheiten am Ende der besagten momentanen Zeitdauer, welche einer Zeitdauer (PE) der Zeitverschachtelung entspricht, gefiltert und anschließend entschachtelt werden.

12. Computerprogramm, welches in einen mit einem Prozessor assoziierten Speicher geladen werden kann und Instruktionen enthalt, um ein Verfahren nach einem beliebigen der Ansprüche 7 bis 11 anzuwenden, wenn das besagte Programm von dem Prozessor ausgeführt wird.

13. Datenträger, auf welchem das Computerprogramm nach Anspruch 12 gespeichert ist.
